# EUROPEAN PATENT APPLICATION

(11) **EP 4 749 318 A1**
(43) Date of publication of application: **27.05.2026**
(21) Application number: 25217586.4
(22) Date of filing: 21.11.2025
(51) Int. Cl.: G01S 7/02, G01S 13/931, H01Q 1/02, H05K 7/20

(54) **RADAR DEVICE**

(30) Priority: 26.11.2024 KR 20240171174
(71) Applicant: bitsensing Inc, Seongnam-si, Gyeonggi-do 13105 (KR)
(72) Inventor: KIM, Dong Hui, 14035 Anyang-si, Gyeonggi-do (KR); LEE, Dae Han, 21024 Incheon (KR)
(74) Representative: BCKIP Part mbB

(57) **Abstract**

A radar device includes a housing configured to have a shape in which at least a portion of one surface in a transmission direction of radar signals is open; a circuit board configured to be disposed inside the housing and include a radar chip; a radome configured to be integrally coupled to the housing to cover at least a portion of the one surface of the housing; and a heat sink configured to be integrally formed with the housing and thermally connected to the radar chip.

## Description

### CROSS-REFERENCE TO RELATED APPLICATION

This application claims the benefit of Korean Patent Application No. 10-2024-0171174 filed on Nov. 26, 2024, with the Korean Intellectual Property Office.

### TECHNICAL FIELD

The present disclosure relates to a radar device.

### BACKGROUND

A vehicle is equipped with an electronic control unit (ECU) for electronically controlling various devices, which receives information from sensors or switches installed in the vehicle and processes the received information to perform control functions for improving vehicle safety and steering stability. In general, a radar device that senses a distance between surrounding objects and the vehicle by transmitting electromagnetic waves and receiving the electromagnetic waves reflected from the objects is used in the vehicle. As vehicles become smaller and performance requirements increase, the space available for installing radar devices is decreasing, and the radar devices themselves are therefore becoming more compact.

Radar devices installed in vehicles or other commercial radar devices often use housings formed of plastic materials in order to reduce manufacturing costs. In such cases, heat generated by the radar chip may cause an increase in internal temperature, which can frequently lead to malfunctions or operational stoppages. That is, the operational reliability of the radar device may be degraded.

Further, various components are required to improve waterproofing, dustproofing, and heat dissipation performance of the radar device. Thus, the radar device is manufactured through a complicated manufacturing process.

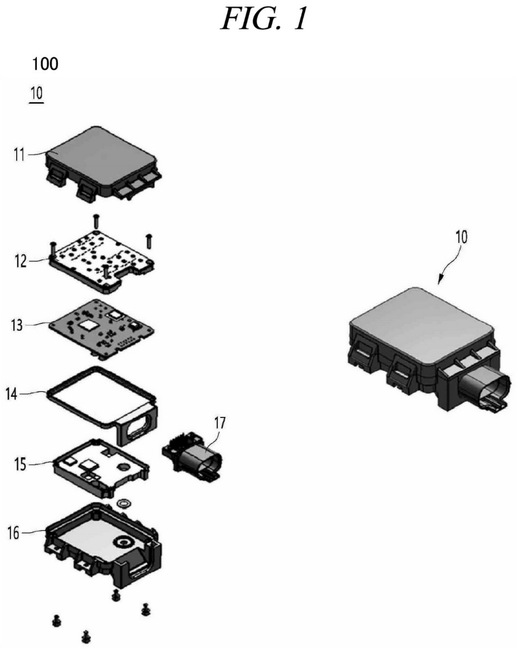

**FIG. 1** shows an exploded perspective view and an assembled perspective view of a radar device according to the prior art.

Referring to **FIG. 1****,** the radar device according to the prior art is manufactured by assembling a large number of components. Specifically, a radar device 10 according to the prior art includes a radome 11, a waveguide 12, a circuit board 13, a shielding member 14, a cavity 15, a housing 16, and a connector 17.

Herein, the shielding member 14 extends between the radome 11 and the connector 17 and the housing 16 to provide waterproofing and dustproofing, the connector 17 is separately coupled to the housing 16, and the cavity 15 is a component configured to dissipate heat from the circuit board 13.

The radar device according to the prior art is manufactured by assembling a large number of components, which leads to a complicated manufacturing process, increased manufacturing costs, and poor maintainability.

### Prior art document

### Patent document

Patent document 1: Korean Patent Laid-open Publication No. 10-2014-0115324

### SUMMARY

In view of the foregoing, the present disclosure is conceived to provide a radar device that achieves improved performance and durability of a radar chip by implementing effective heat dissipation.

Also, the present disclosure is conceived to provide a radar device that can be manufactured through a simplified manufacturing process while ensuring dustproof and waterproof performance.

The problems to be solved by the present disclosure are not limited to the above-described problems. There may be other problems to be solved by the present disclosure.

According to an exemplary embodiment, a radar device may include a housing configured to have a shape in which at least a portion of one surface in a transmission direction of radar signals is open; a circuit board configured to be disposed inside the housing and include a radar chip; a radome configured to be integrally coupled to the housing to cover at least a portion of the one surface of the housing; and a heat sink configured to be integrally formed with the housing and thermally connected to the radar chip.

According to an embodiment of the present disclosure, it is possible to improve performance and durability of a radar chip by implementing effective heat dissipation of the radar chip through thermal connection between a heat sink and the radar chip.

Further, it is possible to reduce manufacturing time and cost through a simplified assembly process by integrally forming a connector and a heat sink with a housing and fixing a circuit board to the housing through connection pins.

### BRIEF DESCRIPTION OF THE DRAWINGS

In the detailed description that follows, embodiments are described as illustrations only since various changes and modifications will become apparent to a person with ordinary skill in the art from the following detailed description. The use of the same reference numbers in different figures indicates similar or identical items.
**FIG. 1** shows an exploded perspective view and an assembled perspective view of a radar device according to the prior art.
**FIG. 2** is an exploded perspective view of a radar device according to an embodiment of the present disclosure.
**FIG. 3** is a top perspective view of the radar device according to an embodiment of the present disclosure.
**FIG. 4** is a bottom perspective view of the radar device according to an embodiment of the present disclosure.
**FIG. 5** is a bottom view of the radar device according to an embodiment of the present disclosure.
**FIG. 6** is a side cross-sectional view of the radar device according to an embodiment of the present disclosure.
**FIG. 7** is an enlarged cross-sectional view of the radar device according to an embodiment of the present disclosure.
**FIG. 8A** to **FIG. 8D** are schematic views of a housing and a heat sink according to various embodiments of the present disclosure.
**FIG. 9A** is an enlarged cross-sectional view of the housing according to an embodiment of the present disclosure.
**FIG. 9B** illustrates an example of a connection pin according to an embodiment of the present disclosure.

### DETAILED DESCRIPTION

Hereinafter, embodiments of the present disclosure will be described in detail with reference to the accompanying drawings to be readily implemented by a person with ordinary skill in the art to which the present disclosure belongs. However, it is to be noted that the present disclosure is not limited to the example embodiments but can be embodied in various other ways. In the drawings, parts irrelevant to the description are omitted in order to clearly explain the present disclosure, and like reference numerals denote like parts through the whole document.

Through the whole document, when a member is said to be located "on" another member, this includes not only the case where the member is in contact with the other member, but also the case where another member exists between the two members.

Through the whole document, when a part "comprises or includes" a certain components, this means that it may further include other components rather than excluding other components unless specifically stated to the contrary.

As used through the whole document, the terms "about", "substantially", etc. are used to mean at or close to that value when manufacturing and material tolerances inherent to the stated meaning are presented, it is used to prevent unscrupulous infringers from taking unfair advantage of disclosures in which precise or absolute figures are mentioned to help understanding of the present disclosure. The term "step of" as used through the whole document does not mean "step for."

Throughout the whole document, the term "combination(s) of" included in Markush type description means mixture or combination of one or more components, steps, operations and/or elements selected from a group consisting of components, steps, operation and/or elements described in Markush type and thereby means that the disclosure includes one or more components, steps, operations and/or elements selected from the Markush group.

Through the whole document, references to "A and/or B" mean "A or B, or A and B."

Hereinafter, embodiments of the present disclosure will be described in detail with reference to the accompanying drawings. However, the present disclosure may not be limited to these implementations, examples, and drawings.

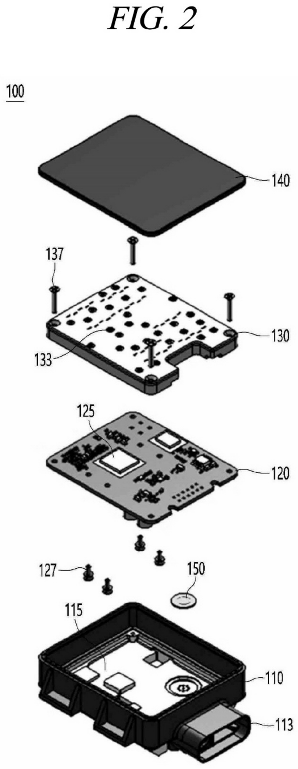

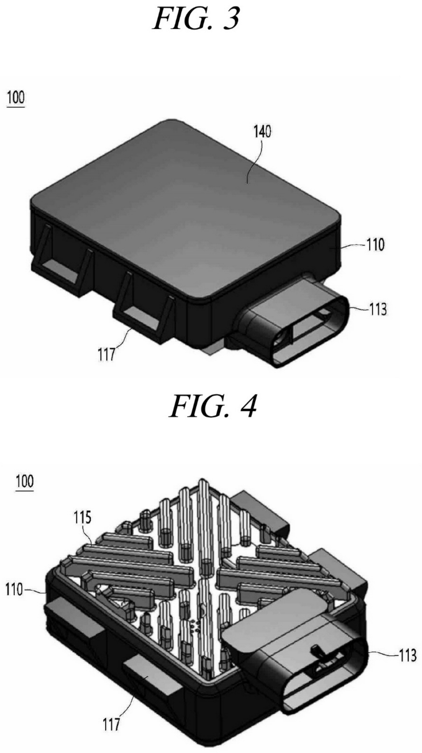

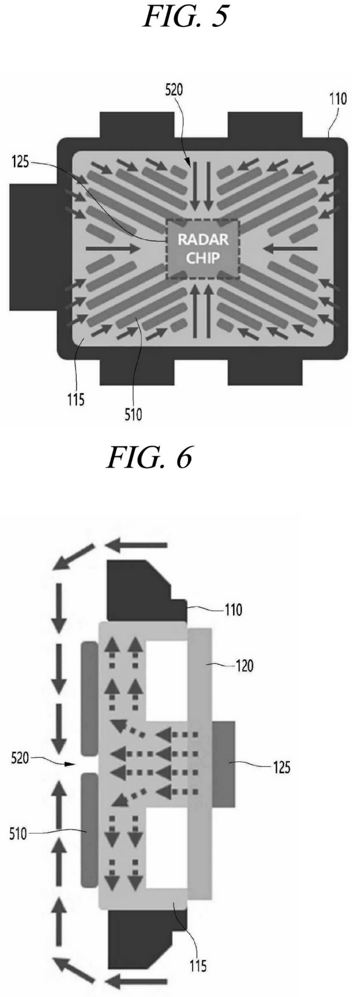

**FIG. 2** is an exploded perspective view of a radar device 100 according to an embodiment of the present disclosure. **FIG. 3** is a top perspective view of the radar device 100 according to an embodiment of the present disclosure. **FIG. 4** is a bottom perspective view of the radar device 100 according to an embodiment of the present disclosure. **FIG. 5** is a bottom view of the radar device 100 according to an embodiment of the present disclosure. **FIG. 6** is a side cross-sectional view of the radar device 100 according to an embodiment of the present disclosure.

Referring to **FIG. 2** to **FIG. 6****,** the radar device 100 according to an embodiment may include a housing 110, a circuit board 120, a waveguide 130, a radome 140, and/or a heat sink 115.

In an embodiment, the housing 110 may have a shape in which at least a portion of one surface (*e.g*., an upper surface) in the transmission direction of radar signals is open. In an embodiment, the housing 110 may be formed with an upper surface, a lower surface, and sidewalls defining an internal space, and at least a portion of the upper surface may be open.

In an embodiment, the housing 110 may include a hook 117 extending outward to be latch-coupled to a mounting position (*e.g*., a vehicle). In an embodiment, the housing 110 may include a plurality of hooks 117 extending outward from respective positions of the sidewalls and configured to be latch-coupled to mounting positions.

In an embodiment, the waveguide 130 may be configured to guide the radiation direction of an antenna arranged on the circuit board 120 and to optimize radiation performance. In an embodiment, the waveguide 130 may be fixedly coupled to the circuit board 120 by bolts 137.

In an embodiment, the waveguide 130 may include a guide hole 133 that guides the radiation direction of the antenna. In an embodiment, the number of guide holes 133 may correspond to the number of antennas.

In an embodiment, the circuit board 120 may be disposed inside the housing 110 and may include a radar chip 125 and an antenna. In an embodiment, the circuit board 120 may extend in a planar direction corresponding to the lower surface of the housing 110 and may be fixedly coupled to the lower surface of the housing 110.

In an embodiment, the radar chip 125 may be disposed at a central portion of the circuit board 120. In an embodiment, the radar chip 125 may be a component that generates relatively high heat on the circuit board 120.

In an embodiment, the circuit board 120 may be fixedly coupled to the housing 110 together with the waveguide 130 by bolts 127.

In an embodiment, the radome 140 may be integrally coupled to the housing 110 to cover at least a portion of the open surface (*e.g*., the upper surface) of the housing 110. In an embodiment, the radome 140 is a component that covers the open surface of the housing 110 to protect the antenna disposed on the circuit board 120 from weather, impact, or foreign substances.

In an embodiment, the radome 140 may be formed of a material having high transmittance and low loss in order to allow radar signals to pass therethrough, and may be designed to minimize signal distortion and to operate efficiently in a radar signal frequency range.

In an embodiment, the radome 140 may be integrally coupled to the housing 110 and may ensure waterproof and dustproof performance at a coupling portion between the radome 140 and the housing 110.

In an embodiment, the heat sink 115 may be integrally formed with the housing 110 and may be thermally connected to the radar chip 125.

In an embodiment, the heat sink 115 may be formed of a metal material having high thermal conductivity. For example, the heat sink 115 may be formed of aluminum (Al).

In an embodiment, the heat sink 115 may be integrally formed with the housing 110 to form a portion of the lower surface of the housing 110. In an embodiment, the heat sink 115 may be directly or indirectly in contact with the radar chip 125 and the circuit board 120 to be thermally connected thereto.

In an embodiment, the housing 110 may may be integrally formed with a connector 113 having electrical or signal ports connected to the outside. In an embodiment, the connector 113 may include ports connected to an external power supply or a control device.

In an embodiment, the connector 113 may be integrally formed with the housing 110 by injection molding or may be insert molded into the housing 110.

Accordingly, an assembly process of assembling the separate connector 113 to the housing 110 may be omitted, and a component for providing dustproof and waterproof performance at a coupling portion between the housing 110 and the connector 113 may also be omitted.

In an embodiment, the heat sink 115 may extend in a planar direction corresponding to the circuit board 120. In an embodiment, at least a portion of the heat sink 115 may be directly or indirectly in contact with the circuit board 120.

In an embodiment, at least a portion of the heat sink 115 may be thermally connected to the circuit board 120 through a thermal pad 700. In an embodiment, the thermal pad 700 may be in surface contact with both the circuit board 120 and the heat sink 115 to transfer heat.

In an embodiment, the heat sink 115 may form at least a portion of the other surface (*e.g*., the lower surface) of the housing 110. In an embodiment, the heat sink 115 may form part or all of the lower surface of the housing 110.

In an embodiment, the heat sink 115 may include a plurality of heat dissipation fins 510 protruding outward from a planar plate extending in a planar direction. In an embodiment, the plurality of heat dissipation fins 510 may extend in a longitudinal direction and may be spaced apart from one another in a transverse direction intersecting the longitudinal direction to guide airflow.

In an embodiment, the plurality of heat dissipation fins 510 extending in the longitudinal direction may be radially arranged from a position corresponding to the radar chip 125, which may be located at the central portion of the circuit board 120 and the heat sink 115.

In an embodiment, the plurality of heat dissipation fins 510 may extend in one direction while passing through the position corresponding to the radar chip 125 in the heat sink 115 and may be arranged to form airflow guide channels 520.

In an embodiment, the airflow guide channels 520 may extend through the position corresponding to the radar chip 125, and the adjacent heat dissipation fins 510 may be spaced apart from each other. In an embodiment, the airflow guide channels 520 may be formed by an increased spacing between the adjacent heat dissipation fins 510, and the airflow may be guided by the heat dissipation fins 510.

In an embodiment, the heat sink 115 may include the plurality of heat dissipation fins 510 extending in a diagonal direction and arranged radially from the position corresponding to the radar chip 125, and the plurality of heat dissipation fins 510 may be spaced apart from each other to form the airflow guide channels 520. In an embodiment, the heat dissipation fins 510 may be omitted in the airflow guide channels 520.

In an embodiment, the heat sink 115 may be divided into four regions based on the radar chip 125 located at the central portion, and a plurality of heat dissipation fins 510 may extend in the respective regions in the diagonal direction. In an embodiment, an airflow guide channel 520 in which no heat dissipation fins 510 are present may be formed between the four regions and may extend through the central portion.

Accordingly, the airflow may be guided to converge toward or diffuse from the central portion where the radar chip 125 is located, and, thus, heat can be uniformly distributed.

In an embodiment, an air vent 150 configured to allow air to pass therethrough may be formed in the heat sink 115. In an embodiment, the air vent 150 may be formed to provide continuous ventilation inside the housing 110 while suppressing infiltration of contaminants into the housing 110. In an embodiment, the air vent 150 may be configured to automatically regulate an internal pressure of the housing 110.

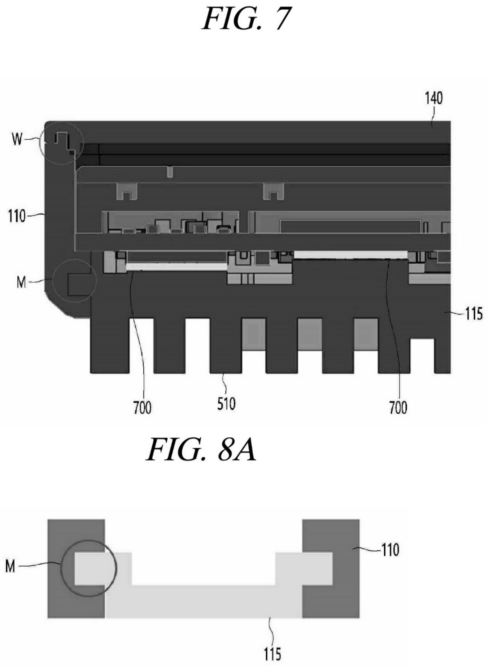

**FIG. 7** is an enlarged cross-sectional view of the radar device 100 according to an embodiment of the present disclosure. **FIG. 8A** to **FIG. 8D** are schematic views of the housing 110 and the heat sink 115 according to various embodiments of the present disclosure.

In an embodiment, the housing 110 may be injection molded in a state in which the heat sink 115 is inserted.

In an embodiment, the heat sink 115 may be injection molded from a metal material and the housing 110 may be injection molded in a state in which the heat sink 115 is inserted. Accordingly, the housing 110 and the heat sink 115 may be manufactured through a double-injection molding process.

Accordingly, the heat sink 115 can effectively dissipate internal heat to the outside. By improving heat dissipation of the radar chip 125 that generates heat at high temperature, the heat sink 115 may be effective in maintaining performance and durability of the radar chip 125.

In an embodiment, at least a portion of the heat sink 115 may be inserted into a groove of the housing 110 to be fixedly latch-coupled (M) to the housing 110. In an embodiment, the groove may be formed as the housing 110 is injection molded in a state in which the heat sink 115 having a protrusion is inserted, and the protrusion of the heat sink 115 may be inserted into the groove to be fixedly latch-coupled (M) to the housing 110.

In an embodiment, the heat sink 115 may include a lateral protrusion to be inserted into the sidewall of the housing 110 and may be latch-coupled to the housing 110 in a state in which an outer end of the heat sink 115 is inserted into the groove of the housing 110.

Accordingly, the coupling between the housing 110 and the heat sink 115 may become more robust, thereby improving durability against external impact. Further, due to the close coupling between the housing 110 and the heat sink 115, heat may be effectively dissipated and heat transfer may be smoothly performed, which can be advantageous for thermal management of the product.

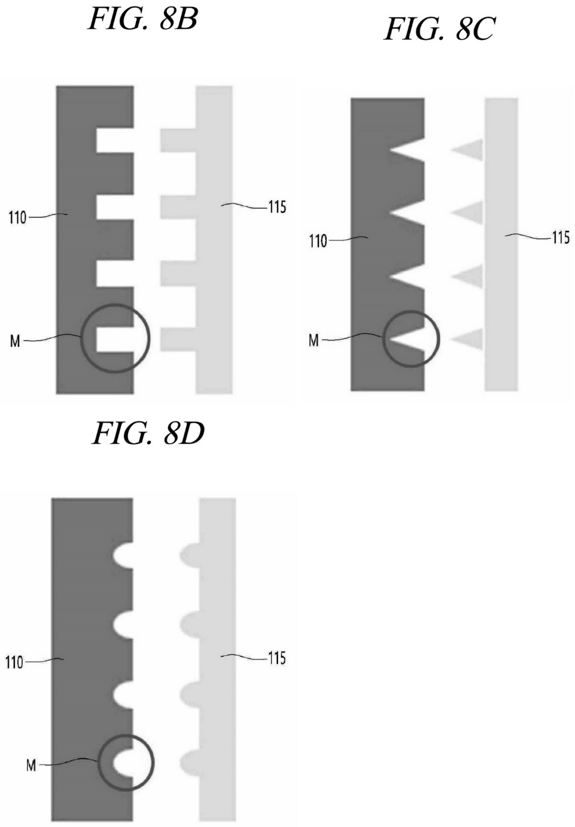

In an embodiment, as shown in **FIG. 8B****,** the outer end of the heat sink 115 may be formed into a sawtooth shape. In another embodiment, as shown in **FIG. 8C****,** the outer end of the heat sink 115 may be formed into a triangular protrusion shape. In still another embodiment, as shown in **FIG. 8D****,** the outer end of the heat sink 115 may be formed into a circular protrusion shape.

Accordingly, the housing 110 formed of a resin material (e.g., plastic) may be brought into close contact with uneven portions of the heat sink 115 formed of a metal material, thereby significantly enhancing mechanical coupling strength. Even during thermal expansion and contraction, the coupling portion may remain robust. Also, structural stability may be improved by evenly distributing thermal and mechanical stress.

In an embodiment, the radome 140 may be laser-welded (W) to the housing 110 in a state in which an outer end of the radome 140 is in contact with a sidewall of the housing 110 and may be thus coupled to the housing 110. Accordingly, durability against external impact may be improved through a minimum number of processes.

In an embodiment, the radome 140 may extend in a planar direction to cover the upper surface of the housing 110, and the outer end of the radome 140 may extend to the sidewall of the housing 110. In an embodiment, a groove may be formed at the outer end of the radome 140, and a protrusion may be formed on the sidewall of the housing 110. Thus, the radome 140 may be latch-coupled to the housing 110 to suppress lateral movement.

In an embodiment, the radome 140 may be primarily latch-coupled to the sidewall of the housing 110 and then laser-welded (W) to be coupled to the housing 110. In an embodiment, the radome 140 may be laser-welded (W) along an entire circumference where the radome 140 is in contact with the sidewall of the housing 110. Accordingly, dustproof and waterproof performance between the radome 140 and the housing 110 may be secured.

Herein, the laser welding (W) may be a method in which a laser beam passes through a transmissive material and reaches an absorptive material, and absorbed heat causes the two polymers to melt and bond together by thermal conduction.

In an embodiment, the protrusion of the sidewall of the housing 110 may be temporarily melted and integrally coupled to the groove of the radome 140.

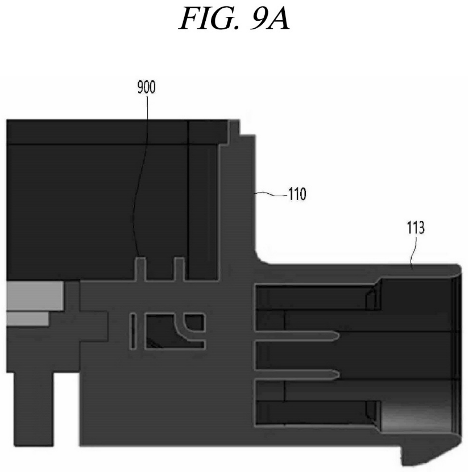

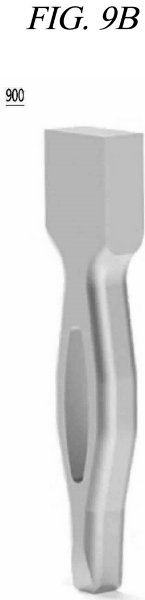

**FIG. 9A** is an enlarged cross-sectional view of the housing 110 according to an embodiment of the present disclosure. **FIG. 9B** illustrates an example of a connection pin 900 according to an embodiment of the present disclosure.

Referring to **FIG. 9A** and **FIG. 9B****,** at least one press-fit type connection pin 900 protruding from the other surface (*e.g*., the lower surface) may be formed in the housing 110 according to an embodiment.

In an embodiment, at least one connection pin 900 may be formed to protrude upward from the lower surface of the housing 110. In an embodiment, the connection pin 900 may be partially embedded in the housing 110 by being inserted into a mold prior to injection molding of the housing 110.

In an embodiment, the connection pin 900 may be disposed adjacent to the connector 113, with one end protruding from the lower surface of the housing 110 and the other end disposed at an end of the connector 113 to be connectable to an external device. In an embodiment, the connection pin 900 may be electrically or signal-wise connected to the circuit board 120.

In an embodiment, the circuit board 120 may be press-fitted to the at least one connection pin 900 and may be fixedly coupled to the housing 110.

Accordingly, the circuit board 120 may form a strong mechanical connection with the connection pin 900 and the housing 110 under high pressure and may be assembled through a simplified process, which enables fast and simplified assembly.

In an embodiment, the circuit board 120, the connection pin 900, and the connector 113 may employ a 1000Base-T1 interface, which is a type of Ethernet technology mainly used in the automotive field. The 1000Base-T1 interface may support a transmission speed of 1 Gbps.

The above description of the present disclosure is provided for the purpose of illustration, and it would be understood by a person with ordinary skill in the art to which the present invention belongs that various changes and modifications may be made without changing technical conception and essential features of the present disclosure. Thus, it is clear that the above-described examples are illustrative in all aspects and do not limit the present disclosure. For example, each component described to be of a single type can be implemented in a distributed manner, likewise, components described to be distributed can be implemented in a combined manner.

The scope of the present disclosure is defined by the following claims rather than by the detailed description of the embodiment, and it should be understood that all modifications and embodiments conceived from the meaning and scope of the claims and their equivalents are included in the scope of the present disclosure.

## Claims

1. A radar device, comprising:
a housing configured to have a shape in which at least a portion of one surface in a transmission direction of radar signals is open;
a circuit board configured to be disposed inside the housing and include a radar chip;
a radome configured to be integrally coupled to the housing to cover at least a portion of the one surface of the housing; and
a heat sink configured to be integrally formed with the housing and thermally connected to the radar chip.

2. The radar device of Claim 1,
wherein the housing is integrally formed with a connector having electrical or signal ports connected to the outside.

3. The radar device of Claim 1,
wherein the housing is injection-molded in a state in which the heat sink is inserted.

4. The radar device of Claim 3,
wherein at least a portion of the heat sink is inserted into a groove of the housing to be latch-coupled to the housing.

5. The radar device of Claim 1,
wherein the heat sink extends in a planar direction corresponding to the circuit board and forms at least a portion of the other surface of the housing.

6. The radar device of Claim 1,
wherein the radar chip is disposed at a central portion of the circuit board, and
the heat sink includes a plurality of heat dissipation fins extending in a longitudinal direction and radially arranged from a position corresponding to the radar chip.

7. The radar device of Claim 6,
wherein the plurality of heat dissipation fins extend in one direction while passing through the position corresponding to the radar chip in the heat sink and are arranged to form airflow guide channels.

8. The radar device of Claim 1,
wherein the heat sink includes a plurality of heat dissipation fins extending in a diagonal direction and arranged radially from a position corresponding to the radar chip, and the plurality of heat dissipation fins is spaced apart from each other to form airflow guide channels.

9. The radar device of Claim 1,
wherein at least a portion of the heat sink is thermally connected to the circuit board through a thermal pad.

10. The radar device of Claim 1,
wherein the radome is laser-welded to the housing in a state in which an outer end of the radome is in contact with a sidewall of the housing.

11. The radar device of Claim 1,
wherein at least one press-fit type connection pin protruding from the other surface is formed in the housing, and
the circuit board is press-fitted to the at least one connection pin and fixedly coupled to the housing.
